# EUROPÄISCHE PATENTSCHRIFT

(11) **EP 1 974 396 B1**
(45) Veröffentlichungstag und Bekanntmachung des Hinweises auf die Patenterteilung: **14.07.2010**
(21) Anmeldenummer: 06829891.8
(22) Anmeldetag: 28.12.2006
(51) Int. Cl.: H01L 31/18, H01L 31/05

(54) **SOLARZELLEN-VERBINDUNGSVORRICHTUNG, STREIFEN-NIEDERHALTEVORRICHTUNG UND TRANSPORTVORRICHTUNG FÜR EINE SOLARZELLEN-VERBINDUNGSVORRICHTUNG**
SOLAR CELL CONNECTING APPARATUS, STRIP RETAINING APPARATUS AND TRANSPORT APPARATUS FOR A SOLAR CELL CONNECTING APPARATUS
DISPOSITIF DE MISE EN CONTACT DE CELLULES SOLAIRES, DISPOSITIF DE MAINTIEN DE BANDES ET DISPOSITIF DE TRANSPORT POUR UN DISPOSITIF DE MISE EN CONTACT DE CELLULES SOLAIRES

(30) Priorität: 30.12.2005 DE 102005063285; 17.02.2006 DE 102006007447
(43) Veröffentlichungstag der Anmeldung: 01.10.2008
(73) Patentinhaber: teamtechnik Maschinen und Anlagen GmbH, 71691 Freiberg (DE)
(72) Erfinder: REINISCH, Hubert, 71691 Freiberg/Neckar (DE)
(74) Vertreter: Lindner, Michael
(86) Internationale Anmeldenummer: PCT/EP2006/012580
(87) Internationale Veröffentlichungsnummer: WO 2007/079972

(56) Entgegenhaltungen:
- WO-A-96/17387
- US-A1- 4 534 502
- US-A1- 4 685 608
- US-A1- 2005 217 718

## Beschreibung

Die vorliegende Erfindung betrifft eine Solarzellen-Verbindungsvorrichtung, vorzugsweise eine Solarzellen-Lötvorrichtung zum Fertigen von Solarzellen-Strings aus einzelnen Solarzellen und elektrisch leitfähigen Streifen, mit einem ersten Modul zum Zusammenführen von Solarzellen und Streifen, einem zweiten Modul, das sich an das erste Modul anschließt (entweder ummittelbar oder mittelbar getrennt durch andere Module etc.), zum Verbinden der Streifen auf die Solarzellen; und einem dritten Modul zum Transport der Solarzellen vom ersten Modul durch das zweite Modul. Die Erfindung betrifft ferner eine Streifen-Niederhaltevorrichtung für eine derartige Solarzellen-Verbindungsvorrichtung sowie eine Transportvorrichtung für eine Solarzellen-Verbindungsvorrichtung.

Solarzellen-Lötvorrichtungen sind allgemein bekannt. Sie dienen dazu, einzelne Solarzellen elektrisch miteinander zu verbinden, wobei das Ergebnis eine Reihenschaltung einzelner Solarzellen zu einem sog. Solarzellen-String ist. In der Druckschrift DE 201 12 309 U1 ist bspw. ein solcher Solarzellen-String angegeben.

Das Dokument US 4 534 502 A beschreibt eine Solarzellen-Lötvorrichtung.

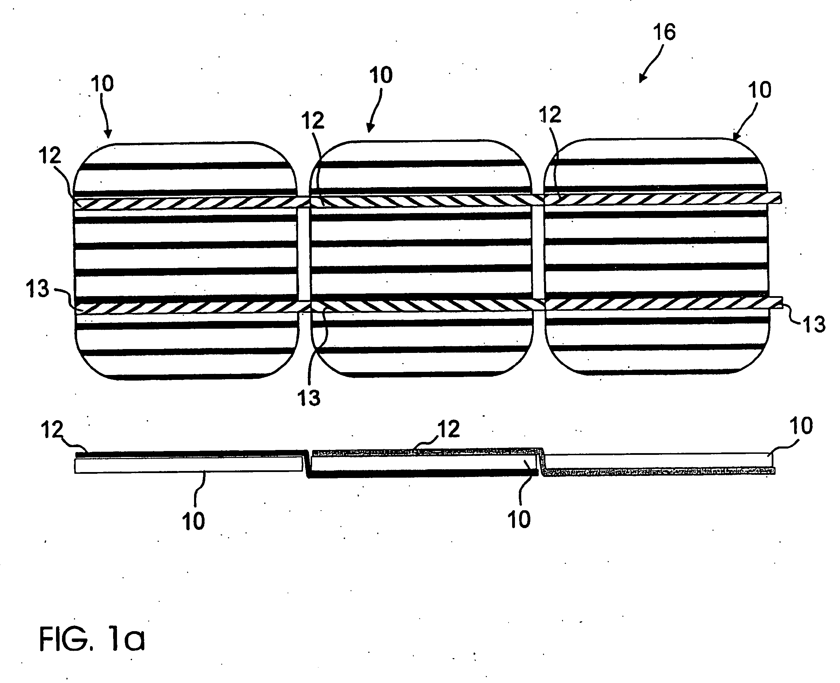

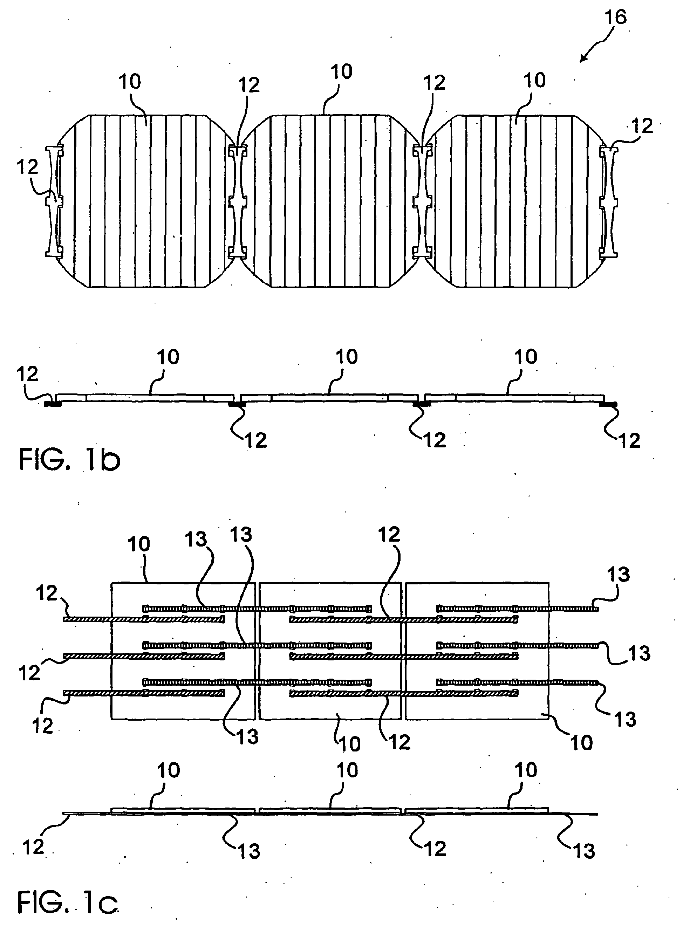

In Fig. 1a ist bspw. ein Ausschnitt eines Solarzellen-Strings 16 gezeigt. Dieser String 16 besteht aus drei Solarzellen 10, die jeweils ein Kontaktgrid aus einzelnen dünnen elektrischen Leitungen besitzen. Senkrecht zu diesem Kontaktgrid verlaufen elektrisch leitfähige Streifen 12, 13, die mit dem Kontaktgrid verlötet sind, um eine elektrische Verbindung herzustellen. Diese Streifen 12, 13 können sich über die gesamte Länge einer Solarzelle und über die Länge der nächsten benachbarten Solarzelle erstrecken, wobei die Streifen dann, wie in Fig. 1a gut zu erkennen ist, auf die gegenüberliegende Seite (Unterseite) der Solarzelle gehen. Ein Streifenpaar 12, 13 verbindet folglich die Oberseite einer Solarzelle 10 mit der Unterseite der benachbarten Solarzelle. Des Weiteren gibt es Solarzellen, wie in Figur 1b, bei denen je ein Streifen quer über die Breite von zwei benachbarten Solarzellen verläuft und dadurch Vorläufer- und Nachfolgerzelle entsprechend der Polung miteinander verbindet.

Bei Figur 1c erstrecken sich Streifen ebenfalls in Längsrichtung benachbarter Zellen ineinander geschachtelt. Die Streifen (bspw. 5 Stk.) verbinden Rückseite mit Rückseite von benachbarten Zellen. Da sich bei Fig. 1b und 1c die Streifen nur auf der Rückseite der Solarzellen befinden, spricht man in diesen Fällen von Rückseitenkontaktzellen.

Diese Arten der Verbindungen werden dann für die gesamte Reihe von Solarzellen wiederholt, so dass am Ende ein aus einer Vielzahl von einzelnen Solarzellen aufgebauter Solarzellen-String entsteht, wobei die elektrische Verbindung der einzelnen Solarzellen über die Streifen 12, 13 erfolgt. Mit dem Begriff "Streifen" wird stellvertretend im Weiteren ein elektrisch leitfähiger Verbinder bezeichnet, der von einer reinen Streifenform (z.B. Fig. 1, 1c) bis zu konturangepassten Geometrien (z.B. Fig. 1b) reichen kann.

Zur Herstellung eines solchen Solarzellen-Strings 16 wurden Solarzellen-Lötvorrichtungen vorgeschlagen, wie bspw. in DE 102 97 633 T5. Bei der dort gezeigten Solarzellen-Aufreihungsmaschine liegen die zu verbindenden Solarzellen auf einer Platte, die mit Hilfe von Schrittmotoren durch die Maschine geführt wird. Auf dieser Platte sind Greifelemente vorgesehen, die die einzelnen Solarzellen greifen und deren Positionen zueinander fixieren. Die zur Verbindung der einzelnen Solarzellen benötigten Streifen werden aufgelegt, ebenfalls an der Solarzelle festgeklemmt und dann durch eine Lötstation gefahren.

Die Verwendung einer Platte zum Transport des Solarzellen-Strings ist u.a. im Hinblick auf eine hohe Taktzahl nachteilig. Darüber hinaus ist sie wenig flexibel im Hinblick auf unterschiedliche Solarzellengrößen, Abstände der Solarzellen im String (Spaltmaß) bzw. eine unterschiedliche Anzahl von Solarzellen in einem Solarzellen-String. Ebenso entstehen Nachteile bei den verschiedenen Zonen des Verbindungsprozesses (z.B. Vorwärm-, Löt-, Abkühlzonen), die aufgrund einer hohen Qualität des Verbindungsprozesses spezifische Prozessparameter erfordern und sich ggf. über größere Streckenlängen erstrecken. Des Weiteren ist die Anzahl der zu verbindenden Solarzellen von der Länge der horizontal bewegten Platte abhängig. Beim Zurückfahren der Platte entsteht ein Leerhub, der sich auf die Ausbringung negativ auswirkt.

Vor diesem Hintergrund besteht die Aufgabe der vorliegenden Erfindung u.a. darin, eine Solarzellen-Verbindungsvorrichtung zu schaffen, die diese Nachteile nicht mehr besitzt. Insbesondere soll die Solarzellen-Verbindungsvorrichtung flexibel einsetzbar sein, einen höheren Durchsatz ermöglichen und eine möglichst große räumliche (z.B. "Zonenlängen") und prozesstechnische Unabhängigkeit von der eingesetzten Verbindungstechnologie (bspw. eines Lötprozesses) aufweisen.

Diese Aufgabe wird bei der eingangs genannten Solarzellen-Verbindungsvorrichtung dadurch gelöst, dass das erste Modul eine Vorrichtung zum Zuführen eines Streifen-Niederhalteelements aufweist, mit dem die Streifen beim Transport an der Solarzelle fixiert werden, und das dritte Modul ausgebildet ist, um das Niederhalteelement zusammen mit der Solarzelle und den daran fixierten Streifen zu transportieren.

D.h. mit anderen Worten, dass die erfindungsgemäße Solarzellen-Verbindungsvorrichtung sich im Gegensatz zu der eingangs erläuterten Solarzellen-Aufreihungsmaschine Fließfertigungsprinzipien zu Nutze macht, um eine flexible Vorrichtung mit hohem Durchsatz realisieren zu können. Die zu einem Solarzellen-String angeordneten einzelnen Solarzellen werden erfindungsgemäß also nicht auf einer Transportplatte mittels Greifelementen gehalten, sondern werden vielmehr auf Transportbänder direkt oder indirekt aufgelegt und durch die einzelnen Bearbeitungsstationen, insbesondere eine Lötstation, transportiert. Indirekt bedeutet in diesem Zusammenhang, dass zwischen Transportbändern und Solarzelle ein weiteres Bauteil liegt, d.h. die Solarzelle liegt folglich auf dem Bauteil, das seinerseits auf den Transportbändern liegt. Um die zur Verbindung der einzelnen Solarzellen notwendigen elektrisch leitenden Streifen auf einer Solarzelle festzuhalten, werden Streifen-Niederhalteelemente eingesetzt, die - bspw. nachdem die Streifen auf die Solarzelle aufgelegt sind - darauf aufgesetzt werden und damit die Streifenelemente auf der Solarzelle andrücken und fixieren. Das entsprechende Niederhalteelement wird dann zusammen mit der Solarzelle weitertransportiert und nach Durchlaufen der Lötstation wieder abgehoben.

Im Rahmen dieser Beschreibung wird der Begriff Verbinden, Löten stellvertretend für eine beliebige Aufbau- und Verbindungstechnik (AVT) zum elektrischen Verbinden (z.B. Löten, Leitkleben, etc.) der Solarzellen verwendet. Ferner ist an dieser Stelle anzumerken, dass das zweite Modul zum Verbinden der Streifen sich nicht notwendigerweise direkt an das erste Modul anschließen muss. Es könnten weitere Module zwischen erstem und zweitem Modul vorgesehen sein.

Mit Hilfe dieser Art von Fertigung ist es möglich, die Anzahl der einen String bildenden einzelnen Solarzellen einfach zu verändern, da bauliche Veränderungen nicht erforderlich sind. Darüber hinaus können die Solarzellen in einer stetigen schrittweisen Bewegung durch die Anlage geführt werden. Der Rücktransport einer Transportplatte nach Fertigen eines Strings, wie dies in dem oben genannten Stand der Technik erforderlich ist, kann folglich entfallen, so dass diese Leerlaufzeit eingespart werden kann.

Bei einer bevorzugten Weiterbildung der erfindungsgemäßen Solarzellen-Lötvorrichtung weist das dritte Modul eine erste Transporteinrichtung auf, die ein erstes Transportband umfasst, das die Solarzelle abstützt. Ferner weist das erste Transportband bevorzugt mehrere in Transportrichtung angeordnete Saugöffnungen auf, die mit Saugkästen zusammenwirken, um auf dem Transportband liegende Solarzellen darauf zu fixieren.

Diese Maßnahme hat sich als besonders vorteilhaft herausgestellt, um die Solarzellen einfach, präzise und insbesondere schonend auf dem Transportband lagezufixieren. Eine genaue Lagefixierung ist so lange notwendig, wie die die einzelnen Solarzellen verbindenden Streifen noch nicht verbunden, bspw. festgelötet, sind.

Bei einer bevorzugten Weiterbildung weist das dritte Modul eine zweite Transporteinrichtung auf, die zwei parallel angeordnete Transportbänder umfasst, auf denen das Streifen-Niederhalteelement zum Transport aufliegt. Bevorzugt weisen die zwei parallelen Transportbänder in deren Längsrichtung angeordnete Saugöffnungen auf, die mit Saugkästen zusammenwirken, um die Niederhalteelemente auf den Transportbändern zu fixieren. Durch diese Ausgestaltung ist in String-Erzeugungsrichtung ein wahlfreies Aufsetzen der Niederhalter auf diese beiden Transportbänder möglich, ohne z.B. Koordination von Formelementen etc. sicherstellen zu müssen.

Diese Maßnahmen haben sich ebenfalls als vorteilhaft herausgestellt. Die Trennung der Transportbänder für die Solarzellen und die Niederhalteelemente ermöglicht eine mechanische Entkopplung, so dass mechanische Einflüsse auf das Transportband für die Solarzellen reduziert werden können. Darüber hinaus hat diese Maßnahme Kostenvorteile, da bei einer Veränderung der Solarzellengrößen bspw. nur deren Transportband geändert werden muss, die beiden parallel dazu verlaufenden Transportbänder für die Niederhalteelemente jedoch verbleiben können.

Bei der zuvor erläuterten Ausführungsform dient das erste Transportband einerseits dazu, Streifen und Solarzelle abzustützen und andererseits die Solarzelle zu transportieren. In einer alternativen Ausgestaltung könnten diese beiden Funktionen auch von dem auf den zweiten Transportbändern aufliegenden Niederhalteelement erbracht werden. In diesem Fall könnte auf das erste Transportband verzichtet werden.

In einer ersten Ausgestaltung wird das Niederhalteelement mit Abstützelementen versehen, die die unteren Streifen und die Solarzelle abstützen. Dadurch, dass das Niederhalteelement auf den zweiten Transportbändern aufliegt, erfolgt somit auch ein Transport der Solarzelle zusammen mit dem Niederhalteelement. Bevorzugt weist das Abstützelement mehrere Abstütznadeln auf, die die Solarzelle sowie die unteren Streifen abstützen.

Bei einer weiteren Ausgestaltung ist das Niederhalteelement zweiteilig aufgebaut, bestehend bspw. aus einer Grundplatte und dem eigentlichen Niederhalteelement, das auf die Grundplatte aufgesetzt wird. Die Grundplatte selbst liegt auf den zweiten Transportbändern und dient dazu, die Solarzelle und die Streifen abzustützen. Das Niederhalteelement wird bei aufgelegter Solarzelle auf die Grundplatte aufgelegt. Kurz gesagt wird bei dieser Ausgestaltung die Funktion des ersten Transportbands durch die Grundplatte ersetzt. Bevorzugt weisen die zwei parallelen Transportbänder in deren Längsrichtung angeordnete Saugöffnungen auf, die mit Saugkästen zusammenwirken um die Niederhalteelemente bzw. Grundplatten auf den Transportbändern zu fixieren.

Selbstverständlich sind weitere Ausgestaltungen denkbar, ohne den Umfang der Erfindung, wie er in den Ansprüchen definiert ist, zu verlassen.

In einer bevorzugten Weiterbildung weisen die erste und die zweite Transporteinrichtung eine gemeinsame Antriebseinrichtung auf.

Diese Maßnahme hat den Vorteil, dass einerseits Kosten für die Bereitstellung eines zweiten Antriebs eingespart werden können, und zum anderen Maßnahmen zur Synchronisation der Transportgeschwindigkeiten beider Transportbänder entfallen können, wenn sie über den gleichen Motor angetrieben werden.

In einer bevorzugten Weiterbildung weist das dritte Modul eine dritte Transporteinrichtung auf, die ausgelegt ist, Niederhalteelemente am Ende des zweiten Moduls oder ggf. nach weiteren prozesstechnischen Zwischenschritten von der Solarzelle abzuheben und zurück zum ersten Modul zu transportieren.

Diese Maßnahme hat den Vorteil, dass im Sinne einer Fließfertigung die nach dem Verbinden, vorzugsweise Löten nicht mehr benötigten Niederhalteelemente zurückgeführt werden können, um dann wieder auf die Solarzellen aufgelegt zu werden. Damit ist ein geschlossener Kreislauf im Hinblick auf die Niederhalteelemerite möglich.

In einer bevorzugten Weiterbildung ist im zweiten Modul eine Verbindungseinrichtung, vorzugsweise ein Lötofen oder eine Löteinrichtung zum ggf. Vorwärmen, Verlöten und ggf. sanften Abkühlen der Streifen auf den Solarzellen vorgesehen, wobei die Solarzellen den Lötofen auf dem Transportband liegend zusammen mit dem Niederhalteelement durchlaufen.

In einer bevorzugten Weiterbildung weist die erste Transporteinrichtung eine Leisteneinrichtung auf, die mehrere sich in Transportrichtung erstreckende Leisten umfasst, auf denen die Transportbänder aufliegen, wobei die Leisten ausgebildet sind, um die Dicke des zwischen Solarzelle und Transportband liegenden Streifens auszugleichen. Bei Rückseitenkontaktzellen wird ohne Höhenversatz gearbeitet. Bevorzugt sind die Leisten auswechselbar ausgestaltet.

D.h. mit anderen Worten, dass zum Transport der Solarzellen insgesamt drei (oder z.B. fünf, je nach Solarzellengröße, -Typ und Anordnung der Streifen) parallel angeordnete Transportbänder eingesetzt werden, die durch sog. Leisten nach unten abgestützt werden. Die Transportbänder sind so angeordnet, dass die zwei äußeren unterhalb der Streifen liegen. Um nun die fehlende Dicke eines Streifens bezüglich des mittleren Transportbands auszugleichen, kann die mittlere Leiste etwa um die Dicke des Streifens höher ausgebildet sein.

Damit lässt sich gewährleisten, dass die Solarzelle absolut plan auf den Transportbändern aufliegt, so dass Bruchbeschädigungen vermieden werden können.

Da die Leisten auswechselbar gestaltet sind, können sehr schnell Veränderungen vorgenommen werden, um die Vorrichtung auf andere Solarzellentypen bzw. Streifendicken einzustellen.

Mit anderen Worten haben die Leisten quasi die Funktion von Adaptern, die einen Höhenausgleich zwischen Streifenbereich und "Nicht-Streifenbereich" schaffen.

In einer bevorzugten Weiterbildung weisen die einzelnen Leisten Längsabschnitte auf, die Saugöffnungen aufweisen, die mit den Saugkästen zum Ansaugen der Solarzellen zusammenwirken.

Diese Maßnahme hat den Vorteil, dass sehr flexibel durch Einsatz unterschiedlicher Leisten das Saugverhalten eingestellt werden kann. Werden Längsabschnitte der Leisten ohne Öffnungen vorgesehen, können Bereiche ohne Besaugung geschaffen werden. Durch unterschiedliche "Rasterung" von Saugöffnungen in der Leiste kann darüber hinaus die besaugte Fläche bzw. die Saugleistung eingestellt werden.

Die Verwendung auswechselbarer Leisten ermöglicht folglich ein sehr variables Einstellen der Saugeigenschaften zusätzlich zu der oben bereits erwähnten Adäpterfunktion.

Die Leisten können darüber hinaus dazu genutzt werden, optimale Prozessparameter für die Aufbau- und Verbindungstechnik zu erzeugen (Wärmeenergie durch stellenweise Beheizung der Leiste, stellenweise Kühlung der Leiste, Isolation der Leiste (wärmetechnisch), usw.).

Bevorzugt weist das erste Modul eine Vorrichtung zum Zuführen einer Solarzelle und eine weitere Vorrichtung zum Zuführen eines oder mehrerer Streifen auf.

Die Erfindung betrifft auch - wie bereits erwähnt - sog. Streifen-Niederhaltevorrichtungen, die in der Solarzellen-Verbindungsvorrichtung, insbesondere der erfindungsgemäßen Solarzellen-Lötvorrichtung zum Einsatz kommen können. Erfindungsgemäß besitzt eine Streifen-Niederhaltevorrichtung einen Rahmen oder c-förmigen Träger, der an seinen beiden Randbereichen Auflageflächen aufweist, die vorzugsweise ausgelegt sind, um auf Transportbändern plan aufzuliegen, und der im mittleren Bereich ein Fenster aufweist, eine Vielzahl von Niederhalteköpfen, die in bspw. zwei Reihen seitlich des Fensters angeordnet sind und jeweils eine oder mehrere Niederhaltenadeln aufweisen, wobei die Niederhalteköpfe schwenkbar am Rahmen gehalten sind, derart, dass die Niederhaltenadeln auf einen Streifen unterhalb des Fensters bewegbar sind.

D.h. mit anderen Worten, dass die erfindungsgemäße Streifen-Niederhaltevorrichtung Niederhalteköpfe aufweist, deren Nadeln beim Aufsetzen der Niederhaltevorrichtung auf eine Solarzelle die Streifen auf die Solarzelle drücken und damit fixieren. Die auf die Streifen über die Niederhaltenadeln aufgebrachte Kraft wird durch Gewichtskraft des jeweiligen Niederhaltekopfs erzeugt und/oder durch Federkraft, die zu einer Verschwenkung des Niederhaltekopfs führt.

Je nach Ausgestaltung der Solarzellen-Verbindungsvorrichtung ist die Niederhaltevorrichtung entsprechend angepasst. Wie zuvor erläutert, sind Ausgestaltungen der Solarzellen-Verbindungsvorrichtung denkbar, bei denen das erste Transportband, welches die Solarzellen abstützt und transportiert, wegfällt. In diesem Fall übernimmt die Streifen-Niederhaltevorrichtung die Funktion dieses Transportbands, insbesondere die Abstützfunktion. Die Niederhaltevorrichtung verfügt vorzugsweise über Abstützelemente im Bereich des - nicht mehr vorhandenen - ersten Transportbands, auf die die Solarzelle aufgelegt wird.

Bevorzugt sind diese Abstützelemente in Form von schmalen kleinbauenden nadelartigen Elementen aufgebaut, um insbesondere einen guten Zugang von der Unterseite zu der Solarzellenunterseite zu ermöglichen.

Alternativ kann das Abstützelement auch als Grundplatte ausgeführt sein, die auf den zweiten Transportbändern aufliegt und - nach dem Auflegen der Solarzelle - das eigentliche Niederhalteelement aufnimmt.

Bevorzugt werden die Niederhalteköpfe durch ihr eigenes Gewicht geschwenkt, um die Niederhaltenadeln nach unten auf den Streifen zu bewegen. Bevorzugter ist den Niederhalteköpfen jeweils zumindest eine Feder zugeordnet ist, die die Bewegung der Niederhaltenadeln nach unten auf die Streifen bewirken.

Um die Flexibilität, die Sicherheit bezüglich Beschädigungen von Zellen oder Streifen und die Prozesssicherheit zu erhöhen, weisen die Niederhaltenadeln federnde, vorzugsweise mäanderförmige Abschnitte auf, so dass sie beim Kontaktieren des Streifens nachgeben können.

Auf diese Art und Weise können Toleranzen bezüglich der Dicke der Streifen und Fertigungstoleranzen in den Niederhalteköpfen auf einfache Art und Weise ausgeglichen werden.

Insgesamt ist es also nicht mehr - wie im Stand der Technik - notwendig, die Streifen mittels Greifelementen auf der Solarzelle festzuklemmen. Vielmehr genügt es, durch Aufbringen einer nur in eine Richtung wirkenden Niederhaltekraft die Streifen präzise zu fixieren.

In einer bevorzugten Weiterbildung ist eine jeweils einer Reihe von Niederhalteköpfen zugeordnete Lagerleiste mit V-förmiger Nut vorgesehen, wobei die Niederhalteköpfe in der Nut schwenkbar gelagert sind.

D.h. mit anderen Worten, dass die Niederhalteköpfe nicht fest eingespannt sind, sondern mehr oder weniger lose in der V-förmigen Nut liegen und über eine entsprechende gegenüberliegende Leiste gegen Herausfallen gesichert sind. Die Niederhalteköpfe sind folglich nicht fest im Rahmen eingespannt.

Das hat den Vorteil, dass die beim Durchlaufen der Vorrichtung auftretenden Temperaturschwankungen und der sich daraus ergebenden Materialausdehnungen keine Verklemmung, etc. auftreten kann. Bei Aufbringung der Niederhaltekraft mittels Gewichtskraft ergibt sich zudem eine sehr reproduzierbare Kraftaufbringung, die keine Ermüdung, wie z.B. bei Federn möglich, aufweist.

Bevorzugt sind die Niederhalteköpfe nach innen verlagerbar, wobei die Niederhaltenadeln bei einer Verlagerung nach innen nach unten auf einen Streifen geschwenkt werden.

Die Erfindung betrifft - wie erwähnt - auch eine Transportvorrichtung für eine Solarzellen-Verbindungsvorrichtung, insbesondere für die erfindungsgemäße Solarzellen-Verbindungsvorrichtung. Die Transportvorrichtung zeichnet sich dadurch aus, dass zumindest eine Leiste vorgesehen ist, die sich in Transportrichtung erstreckt, und eine in Transportrichtung verlaufende Ausnehmung im Transportvorrichtungs-Rahmen vorgesehen ist, die ausgelegt ist, um die Leiste wechselbar aufzunehmen, wobei die Leiste im eingelegten Zustand das Transportband abstützt.

Bevorzugt sind mehrere Leisten vorgesehen, die parallel zueinander angeordnet sind und sich in Transportrichtung erstrecken, wobei zumindest eine erste Leiste im Bereich eines mit der Unterseite einer Solarzelle zu verbindenden Streifens liegt, und zumindest eine andere zweite Leiste in einem Bereich ohne Streifen liegt. Die in Transportrichtung verlaufenden Ausnehmungen im Rahmen sind ausgelegt, jeweils eine Leiste wechselbar aufzunehmen, wobei die Leisten im eingelegten Zustand das Transportband abstützen und wobei die ersten und die zweiten Leisten unterschiedliche Höhen haben um einen Höhenunterschied bedingt durch die Dicke von Streifen zwischen Solarzelle und Transportband auszugleichen Bevorzugt weist die Leiste zumindest längsabschnittsweise Saugbohrungen aufweist, die sich von der dem Transportband zugewandten Seite zur gegenüberliegenden Seite erstrecken. Weiter bevorzugt ist ein Saugkasten vorgesehen, der mit den Bohrungen zusammenwirkt, um eine auf dem Transportband liegende Solarzelle anzusaugen. Weiter bevorzugt besteht jede Leiste aus mehreren Einzelteilen.

Die Funktion und die Vorteile einer solchen Leiste wurden bereits im Zusammenhang mit der erfindungsgemäßen Solarzellen-verbindungsvorrichtung zuvor ausgeführt, so dass darauf an dieser Stelle nicht weiter eingegangen wird.

Weitere Vorteile und Ausgestaltungen der Erfindung ergeben sich aus der Beschreibung und der beiliegenden Zeichnung. Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Die Erfindung wird nun anhand von Ausführungsbeispielen mit Bezug auf die Zeichnung näher erläutert. Dabei zeigen:
- Fig. 1a, b, c: schematische Darstellungen eines aus drei Solar- zellen bestehenden Solarzellen-Strings;
- Fig. 2: eine schematische Darstellung einer erfindungsgemäßen Solarzellen- Lötvorrichtung;
- Fig. 3: eine schematische perspektivische Darstellung einer erfindungsgemä- ßen Solarzellen-Lötvorrichtung;
- Figuren 4a-e: unterschiedliche Ansichten eines erfindungsgemäßen Streifen- Niederhalteelements;
- Fig. 5a, b, c: verschiedene Ansichten eines erfindungsgemäßen Streifen- Niederhalteelements, gemäß einer Alternative zu dem in Fig. 4 gezeig- ten;
- Figuren 6a-c: schematische Ansichten einer erfindungsgemäßen Transportvorrich- tung mit Leisten,
- Fig. 7: ein schematisches Blockdiagramm einer Solarzellen-Lötvorrichtung gemäß einer anderen Ausführungsform,
- Fig. 8: eine schematische Darstellung eines Niederhaltelements gemäß einer weiteren Ausführungsform, die an den Aufbau der Vorrichtung von Fig. 7 angepasst ist;
- Fig.9: ein schematisches Blockdiagramm einer Solarzellen-Verbindungs- vorrichtung gemäß einer weiteren Ausführungsform, und
- Fig. 10: eine schematische Darstellung eines an die Solarzellen- Verbindungsvorrichtung von Fig. 9 angepassten zweiteiligen Nieder- haltelements.

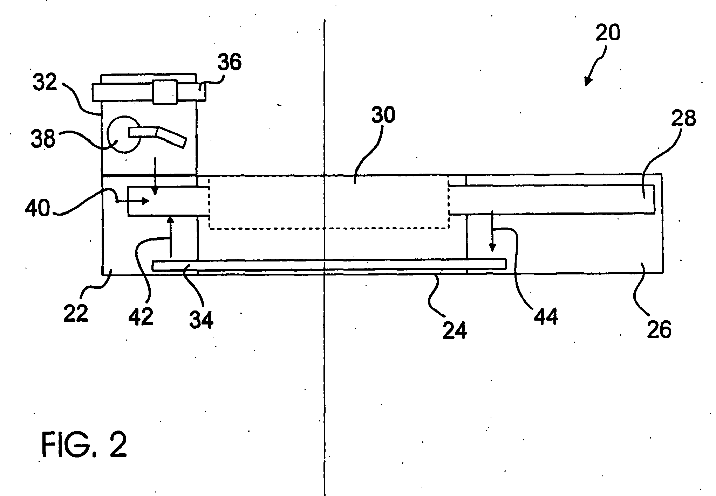

In Fig. 2 ist eine Solarzellen-Lötvorrichtung schematisch als Blockdiagramm dargestellt und mit dem Bezugszeichen 20 gekennzeichnet. Diese schematische Darstellung dient der allgemeinen Erläuterung der Funktionsweise der Solarzellen-Lötvorrichtung und zeigt auf Grund dessen keine technischen Details. Allgemein wird eine solche Solarzellen-Lötvorrichtung 20 auch kurz als Stringer bezeichnet, da mit Hilfe dieser Vorrichtung mehrere Solarzellen zu einem sog. String zusammengefügt werden. Nachfolgend wird die Solarzellen-Lötvorrichtung deshalb kurz als Stringer 20 bezeichnet.

Wie bereits in der Beschreibungseinleitung ausgeführt, werden mehrere einzelne Solarzellen 10, wie in Fig. 1a, 1b, 1c angedeutet, zu einem String zusammengefügt. Zum mechanischen und elektrischen Verbinden benachbarter Solarzellen werden Streifen 12, 13 verwendet, wobei, bei der Solarzellen- bzw. Produktvariante nach Fig. 1a, ein Streifenpaar von der Oberseite einer Solarzelle zur Unterseite der benachbarten Solarzelle verläuft. Der Verlauf der Streifen 12, 13 ist in Fig. 1a deutlich zu erkennen, so dass darauf nicht weiter eingegangen werden soll. In Fig. 1b, 1c sind Rückseitenkontaktzellen gezeigt, bei denen die Verschaltung ausschließlich auf der Solarzellen-Rückseite stattfindet.

Der erfindungsgemäße Stringer kann damit sowohl Solarzellen mit Vorder- und Rückseitenkontakten oder auch Rückseitenkontaktzellen verarbeiten. Die Funktion des mitlaufenden Niederhalters bleibt unverändert. Bei Rückseitenkontaktzellen werden die Solarzellen nicht auf der kratz- und beschädigungsempfindlichen Sonnenseite mit Zangenhälften o. Ä. berührt.

Im Weiteren werden stellvertretend für Rückseitenkontaktzellen und Solarzellen mit Vorder- und Rückseiten nur auf die Zellen nach Fig. 1a im Text bezogen.

Grundsätzlich ist es zur Herstellung eines solchen Solarzellen-Strings 16 erforderlich, die benötigten einzelnen Solarzellen präzise zueinander zu platzieren und die jeweiligen Streifen aufzulegen. In dieser präzisen Ausrichtung zueinander muss die Einheit aus Solarzellen 10 und Streifen 12, 13 verlötet werden. Bisher wurde dies im Stand der Technik entweder dadurch ausgeführt, dass die Solarzellen eines Strings 16 auf einer Transportplatte festgeklemmt und dann in eine Löteinrichtung, vorzugsweise ein Lötofen transportiert wurden. Bei einer anderen bekannten Lösung wurden die beiden Streifen eines Streifen-Paars zunächst auf einer Solarzelle aufgelötet, bevor die nächste Solarzelle platziert wurde.

Der erfindungsgemäße Stringer 20 löst sich von diesen bekannten Prinzipien und stellt eine Art Fließfertigung für Solarzellen-Strings 16 bereit.

Der Stringer 20 umfasst mehrere Module, bspw. 32, 22, 24, 26, welche die notwendigen Prozessschritte nacheinander ausführen. Zwischen diesen Prozessschritten können jederzeit noch produkt- oder kundenspezifische Prozess-Zwischenschritte eingefügt sein. Diese Prozess-Zwischenschritte können einem der unten genannten Module zugeordnet sein, oder ein eigenständiges neues Modul bilden.

Der Stringer 20 umfasst hierfür ein erstes Modul bzw. Auflegemodul 22, das dazu dient, die Solarzellen 10 und die Streifen 12, 13 in ihrer richtigen Position zueinander aufzulegen.

Dem Auflegemodul 22 folgt direkt im Anschluss oder nach Prozesszwischenschritten ein zweites Modul bzw. Verbindungs-Lötmodul 24, das einen Lötofen 30 bzw. eine Löteinrichtung aufweist. Schließlich folgt dem Lötmodul 24 ein viertes Modul bzw. Nachbearbeitungsmodul 26, in dem bspw. Prüfverfahren zur Prüfung der gefertigten Solarzelle-Strings 16 ausgeführt werden, oder bspw. das Auflegen der Strings auf eine Glasplatte.

Den erwähnten Modulen 22, 24 und 26 ist ein drittes Modul bzw. Transportmodul 28 zugeordnet, das zumindest ein Transportband aufweist, welches vom ersten Modul 22 bis zum vierten Modul 26 verläuft und die Solarzellen transportiert.

Des Weiteren ist in Fig. 2 ein fünftes Modul bzw. Magazin-Modul 32 gezeigt, das am ersten Modul 22 angebracht ist und eine Magazintransporteinheit 36 und eine Zellenbewegungs- und Positioniereinrichtung, z.B. einen Roboter 38, umfasst. Dieses Magazin-Modul dient zur Bereithaltung von einzelnen Solarzellen 10 in Magazinen, die über die Magazintransporteinheit 36 in den Handhabungsbereich des Roboters 38 gebracht werden. Der Roboter 38 nimmt aus diesem Magazin nacheinander die einzelnen Solarzellen und legt sie auf das Transportband im Bereich des Auflegemoduls 22 auf. Je nach Erfordernis werden dazwischen noch weitere auf eine einzelne noch nicht verbundene Solarzelle, einwirkende Prozess-Zwischenschritte ausgeführt. Beispielsweise Prüfen und/oder Ausrichten der Solarzellen mechanisch oder mittels Bildverarbeitung.

Zum Zuführen der Streifen 12, 13 ist dem ersten Modul 22 eine Streifenzuführeinheit 40 zugeordnet.

Schließlich weist der Stringer 20 in Fig. 2 noch eine Rücktransporteinheit 34 auf, die sog. Niederhalteelemente, die nachfolgend noch im Detail erläutert werden, vom vierten Modul 26 zurück zum ersten Modul 22 transportiert. Aus Taktzeitgründen kann diese Rücktransporteinheit 34 auch zweifach, d.h. auf beiden Seiten links und rechts von 28 angeordnet sein. Im ersten Modul 22 werden die Niederhalteelemente über eine Handhabungseinrichtung 42 auf die Solarzellen gelegt und über eine entsprechende Handhabungseinrichtung 44 im Bereich des vierten Moduls 26 wieder von den Solarzellen abgehoben und zurücktransportiert.

Der in Fig. 2 schematisch gezeigte Stringer 20 übt nun folgende Funktion aus (der Ablauf ist beispielhaft für Solarzellen mit Vorder-/Rückseitenkontakten nach Fig.1). Bei der Verarbeitung von Rückseitenkontaktzellen sind bei der Erfindung durch Software und Ablaufänderung im Steuerprogramm eine Vielzahl von unterschiedlichen Stringproduktvarianten herstellbar. Dies ist ein weiterer Vorteil.

Die Zellentransporteinrichtung, bspw. ein Roboter 38 entnimmt aus einem Solarzellenmagazin in der Magazintransporteinheit 36 eine einzelne Solarzelle 10 und transportiert sie zum Auflegemodul 22, um sie dort auf das Transportband des Transportmoduls 28 aufzulegen. Anschließend wird das aus den beiden Streifen 12, 13 bestehende Streifen-Paar über die Streifenzuführeinheit 40 auf der Oberseite der Solarzelle platziert, wobei jeweils ein Längsabschnitt der beiden Streifen 12, 13 über die Solarzelle hinausragt und auf dem Transportband liegt.

Anschließend wird über die Handhabungseinheit 42 sog. Niederhalteelemente auf die Solarzelle aufgesetzt, so dass die beiden Streifen 12, 13 auf die Solarzelle aufgedrückt und die beiden Streifen 12, 13 unterhalb der Solarzelle ebenfalls angedrückt und folglich relativ zu dieser fixiert werden. Die Handhabungseinheit 42 kann auch so ausgestaltet sein, dass sie sowohl Streifen wie auch die Niederhalterelemente handhabt. In diesem Fall können beispielsweise Streifen und Niederhalterelement quasi zeitgleich auf die Solarzellen aufgelegt werden.

Im nächsten Schritt wird das Transportband um einen Schritt, der etwa der Länge einer Solarzelle entspricht, weitergetaktet, so dass die lose Einheit aus Solarzelle, Streifen und Niederhalteelement um eine Position weitertransportiert wird. Die losen Streifenabschnitte können bei Vorderkontakt-Solarzellen während des Taktens mittels des Transportbandes und der darin befindlichen Saugöffnungen fixiert werden.

Anschließend wird eine neue Solarzelle über die Zellentransporteinrichtung 38 aus dem Magazin geholt und auf das Transportband gelegt, wobei jetzt die beiden überstehenden Längsabschnitte der Streifen 12, 13 unter der aufgelegten Solarzelle sind. Dann werden wieder zwei Streifen auf diese Solarzelle über die Streifenzuführeinheit 40 aufgelegt und der oben genannte Vorgang wiederholt sich so lange, bis die gewünschte Anzahl von Solarzellen für einen String erreicht ist.

Wird die elektrische Verbindung über mehr als zwei Streifen hergestellt, dann werden entsprechend mehr Streifen aufgelegt.

Dies gilt für die Solarzellen wie bei Fig. 1a beschrieben. Bei den Rückseitenkontaktzellen, bspw. nach Fig. 1b, 1c wird zuerst die Solarzelle mit der Zelltransporteinrichtung 38 auf das Transportband aufgelegt und anschließend die Streifen auf die Rückseiten der beiden Solarzellen aufgelegt. Das Niederhalteelement fixiert die Streifen auf den beiden Solarzellen.

Die auf dem Transportband liegenden Einheiten aus Solarzelle, Streifen und Niederhalteelement werden durch den (Löt)ofen 30, bzw. Löteinrichtung 30 (im Folgenden auch ggf. nur als Lötofen bezeichnet), getaktet und dort erhitzt, um die Streifen auf den Solarzellen mechanisch und elektrisch zu verbinden. Die hierfür einsetzbaren Lötverfahren sind allgemein bekannt und es soll deshalb darauf an dieser Stelle nicht weiter eingegangen werden.

Nach Durchlaufen des Lötofens, bzw. der Löteinrichtung 30 werden im Bereich des vierten Moduls 26 die Niederhalteelemente über die Handhabungseinheit 44 wieder abgehoben und über die Rücktransporteinheit 34 zurück zum Auflegemodul 22 transportiert. Da über die Lötung eine mechanische Verbindung der einzelnen Solarzellen erreicht ist, sind diese Niederhalteelemente folglich nicht mehr erforderlich.

Der mechanisch stabile String 16 wird schließlich in dem vierten Modul 26 nachbearbeitet, wobei hierzu auch Prüfungsverfahren zur elektrischen Prüfung des Strings 16 zu zählen sind. Da diese Nachbearbeitung für die Erfindung nicht wesentlich ist, soll darauf nicht weiter eingegangen werden.

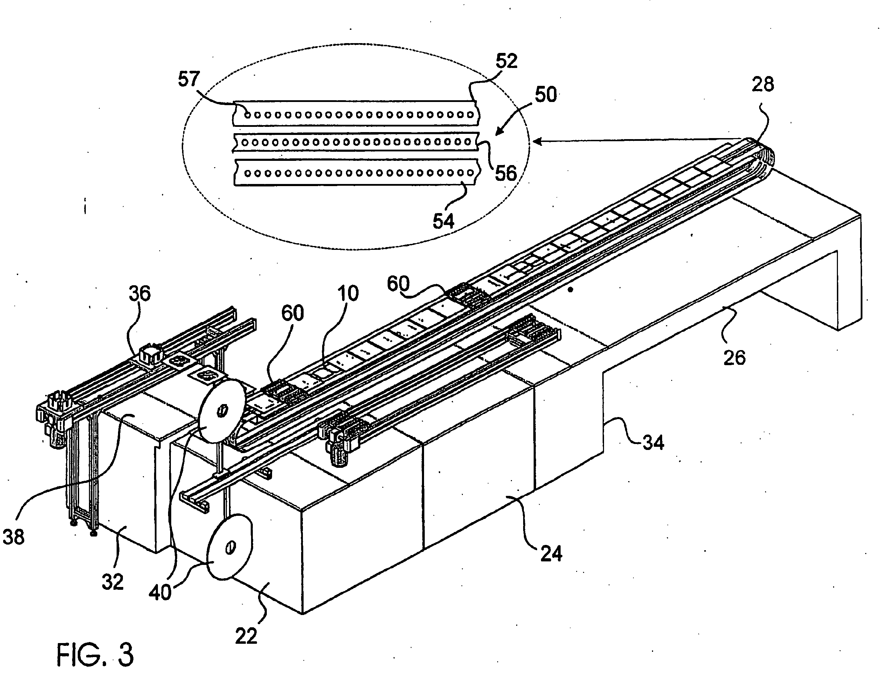

In Fig. 3 ist der allgemeine Aufbau eines Stringers 20 nochmals in einer perspektivischen Darstellung gezeigt. Gut zu erkennen ist dabei der modulartige Aufbau, der insbesondere bei der Planung eines Stringers 20 Vorteile hat, da baukastenartig einzelne bereits früher geplante Module zusammengestellt werden können. So ermöglicht der modulartige Aufbau bspw., dass das Magazin-Modul 32 an unterschiedlichen Seiten des Auflegemoduls 22 angesetzt werden kann. Die einzelnen Abmessungen der Module und die Befestigungsvorrichtungen sind darauf ausgelegt, d.h. es wird eine gewisse Standardisierung von Abmessungen und Befestigungsmöglichkeiten vorgenommen. Das Gleiche gilt im Übrigen auch für die anderen, sich anschließenden Module 24, 26 und 28. So kann das zweite Modul 24, das den Lötofen trägt, unterschiedlich lang sein, um bspw. unterschiedlichen Lötverfahren Rechnung zu tragen. Die unterschiedlichen Längen dieses zweiten Moduls 24 haben jedoch keinen Einfluss auf die davor und dahinter befindlichen Module 22 und 26, da die Verbindungsflächen und entsprechenden Abmessungen standardisiert sind.

In der perspektivischen Ansicht der Fig. 3 ist das Transportmodul 28 genauer dargestellt. Es umfasst eine Transportbandeinheit 50, die aus insgesamt drei einzelnen Transportbändern 52, 54 und 56 besteht. Diese Anzahl von einzelnen Transportbändern ist jedoch rein beispielhaft und hängt alleine von dem Typ von Solarzelle, insbesondere deren Größe, ab. So kann bspw. das Transportband 56 wiederum in mehrere einzelne Transportbänder unterteilt sein.

Die in Fig. 3 drei gezeigten Transportbänder 52 bis 56 verlaufen parallel zueinander und werden über einen gemeinsamen Antrieb, der in der Figur nicht gezeigt ist, angetrieben. Damit ist gewährleistet, dass sich die drei Transportbänder synchron bewegen. Wie bereits angedeutet, werden die Transportbänder nicht kontinuierlich, sondern schrittweise bewegt, um die Solarzellen durch den Stringer 20 zu takten.

Die Transportbänder 52 bis 56 sind bevorzugt aus Metall gefertigt, wobei andere Materialien jedoch auch möglich sind. Allerdings ist bei der Auswahl der Transportbandmaterialien darauf zu achten, dass sie hitzeresistent sind, da die Transportbänder durch den Lötofen bzw. die Löt-/Verbindungseinrichtung verlaufen und damit größeren Temperaturen ausgesetzt sind.

In der Fig. 3 ist ebenfalls zu erkennen, dass die Transportbänder Löcher 57 aufweisen, die in Längsrichtung der Transportbänder in gleichmäßigen Abständen angeordnet sind. Die Funktion dieser Löcher 57 wird später noch erläutert.

Schließlich sind in Fig. 3 noch Niederhalteelemente zu erkennen, die mit dem Bezugszeichen 60 gekennzeichnet sind. Wie bereits angedeutet, werden diese Niederhalteelemente im Auflegemodul 22 auf jeweils eine Solarzelle 10 aufgelegt, um die Streifen 12, 13 auf die Solarzelle 10 zu drücken. Die Niederhalteelemente 60 liegen zum Transport auf den beiden außen liegenden Transportbändern 52 und 54 auf, während die Solarzellen 10 auf dem mittleren Transportband aufliegen. Damit ist eine mechanische Trennung des Transports der Niederhalteelemente 60 und der Solarzellen 10 erreicht, wobei allerdings über die entsprechende Synchronisierung des Antriebs gewährleistet sein muss, dass sich die Einheit aus Solarzelle 10 und Niederhalteelement 60 synchron bewegt. Um eine sichere Platzierung der Streifen auf den Solarzellen während des Transports zu und durch den Lötofen sicherzustellen, darf es zu keiner Relativgeschwindigkeit zwischen Solarzelle 10 und Niederhalteelement 60 kommen.

An dieser Stelle sei angemerkt, dass aus Vereinfachungsgründen nur zwei Niederhalteelemente 60 in Fig. 3 gezeigt sind. In der Praxis wird jedoch ein Niederhalteelement pro Solarzelle verwendet werden.

Die Niederhalteelemente 60 werden nach Durchlaufen des Lötofens im Bereich des vierten Moduls 26 über bspw. eine einfache Bewegungseinrichtung (nicht gezeigt) von den Transportbändern 52, 54 abgehoben und auf die Rücktransporteinheit 34, die bspw. ebenfalls aus zwei Transportbändern bestehen kann, aufgesetzt und zum Auflegemodul 22 zurücktransportiert.

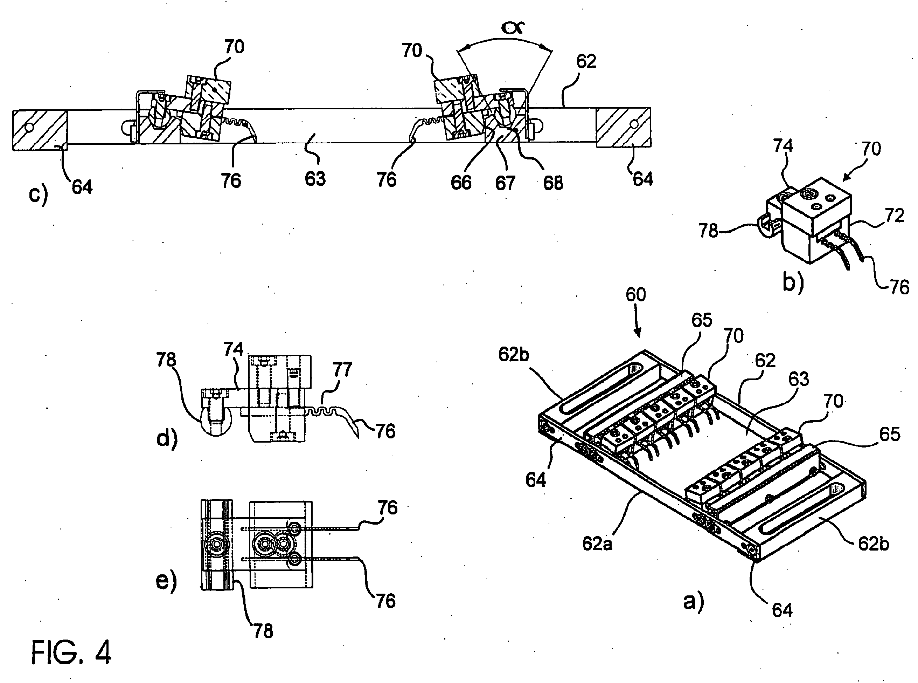

In Fig. 4 ist nun in mehreren schematischen Darstellungen ein Niederhalteelement gezeigt und allgemein mit dem Bezugszeichen 60 gekennzeichnet. Der allgemeine Aufbau eines Niederhalteelements 60 ist sehr gut in Fig. 4a zu erkennen. Das Niederhalteelement 60, nachfolgend auch kurz Niederhalter genannt, besteht aus einem Rahmen 62, der auch nur z.B. c-förmig aufgebaut sein kann, also nicht zwingend geschlossen sein muss, der aus quer verlaufenden (in Bezug auf die Transportrichtung der Niederhalter) Rahmenelementen 62a und diese verbindende Rahmenelemente 62 b besteht. Selbstverständlich ist auch ein anderer Aufbau des Rahmens 62 denkbar.

Wesentlich bei der Ausgestaltung des Rahmens 62 ist, dass in der Mitte ein Fenster 63 verbleibt, dessen Funktion später noch erläutert wird.

Die beiden seitlichen Rahmenelemente 62b besitzen an ihrer Unterseite jeweils eine Auflagefläche 64, die möglichst plan, bzw. mit Saugtaschen, ausgebildet ist. Über diese Auflageflächen 64 liegt der Niederhalter 60 auf den beiden zuvor erwähnten Transportbändern 52, 54 (Fig. 3) auf.

Parallel zu den beiden seitlichen Rahmenelementen 62b sind Rahmenleisten 67 vorgesehen (siehe Fig. 4c) und an den Rahmenelementen 62a befestigt. Die beiden Rahmenleisten 67 begrenzen das Fenster 63 in Querrichtung.

Die beiden Rahmenleisten 67 umfassen nach oben offene, V-förmige Nuten 68, die sich über deren gesamte Länge erstrecken.

Der Niederhalter 60 umfasst eine Vielzahl von Niederhalteköpfen 70, die in mehreren Reihen parallel zu den Rahmenleisten 67 angeordnet sind. Dies ist sehr gut in Fig. 4a zu erkennen.

Jeder Niederhaltekopf 70 umfasst einen Körper 72, der zumindest eine, vorzugsweise zwei Niederhaltenadeln 76 hält. An dem Körper 72 ist an der den Niederhaltenadeln gegenüberliegenden Seite ein Arm 74 angebracht, der an einer Stange 78 befestigt ist. Diese Stange 78 erstreckt sich über einen Niederhaltekopf 70 und wird in der o.g. V-Nut geführt. Mehrere Niederhalteköpfe 70 einer Reihe und die zugehörige Leiste 67 bilden somit eine mechanische Einheit.

Diese mechanische Einheit wird im Rahmen 62 abgestützt. Hierzu liegen die Stangen 78 der Einheit in der V-förmigen Nut 68, wobei an der Rahmenleiste 67 eine Halteleiste 65 vorgesehen ist, die verhindert, dass die Niederhalteköpfe aus der V-Nut 68 herausfallen können.

An dieser Stelle sei angemerkt, dass statt einzelne Stangensegmente 78' eine durchgehende Stange 78, eingesetzt werden kann. Bei Stangensegmenten, wobei jeweils ein Stangensegment 78' einem Niederhaltekopf 70 zugeordnet ist, hat diese Variante gegenüber einer gemeinsamen Stange pro Reihe den Vorteil größerer Flexibilität, die Funktionsweise bleibt jedoch gleich.

Wie sich aus Fig. 4c ergibt, liegt der Körper 72 jedes Niederhaltekopfes 70 im Bereich des Fensters 63. Die Abstützung der Einheit aus Niederhalteköpfen 70 in der V-Nut 68 ermöglicht ein Verschwenken der Einheit (bzw. der einzelnen Niederhalteköpfe bei Einsatz von Stangensegmenten) um einen bestimmten einstellbaren Winkel.

Dieser Schwenkbereich und die Form der Niederhaltenadeln 76 wird so ausgewählt, dass die Nadeln auf die Streifen 12, 13 drücken, wenn der Niederhalter 60 auf eine Solarzelle 10 aufgesetzt wird. Die Anpresskraft, mit der die Streifen auf die Solarzelle gedrückt werden, kann durch entsprechende Einstellung des Gewichts des Körpers 72 vorgenommen werden. Es ist jedoch darauf zu achten, dass die Niederhalteköpfe 70 im aufgelegten Zustand nicht an einem Anschlag 66 an der Rahmenleiste 67 anschlagen. Die Niederhalteköpfe 70 sollen nur dann an diesem Anschlag 66 anliegen, wenn sie nicht auf einer Solarzelle aufliegen, die Niederhaltenadeln also frei liegen.

Wie bereits zuvor erwähnt, durchlaufen die Niederhalter 60 zusammen mit den Solarzellen und den Streifen den Lötofen 30. Um eine möglichst gute Wärmezufuhr zu den zu verlötenden Streifen zu ermöglichen, ist das erwähnte Fenster 63 vorgesehen. Über dieses Fenster 63 kann folglich Lötenergie, bspw. in Form von Heißgas oder Heißluft oder Laserlicht, zugeführt werden.

In Fig. 4d ist gut zu erkennen, dass die Niederhaltenadel 76 einen mäanderförmigen Abschnitt 77 aufweist, der eine federnde Funktion gewährleistet. Damit ist es möglich, Toleranzen, bspw. in Form von Höhenunterschieden benachbarter Niederhaltenadeln auszugleichen, da besonders weit nach unten vorstehende Niederhaltenadeln 76 beim Aufsetzen auf die Solarzellen nach oben federn können, bis die anderen Niederhaltenadeln ebenfalls aufliegen.

Grundsätzlich dienen folglich die Niederhaltenadeln 76 einer Reihe von Niederhalteköpfen 70 dazu, einen auf der Solarzelle 10 liegenden Streifen 12 oder 13 auf die Solarzelle zu drücken und damit zu fixieren. Da der Niederhalter 60 mit der Solarzelle 10 transportiert wird, kann diese Fixierung der Streifen auf der Solarzelle während des Transports beibehalten werden.

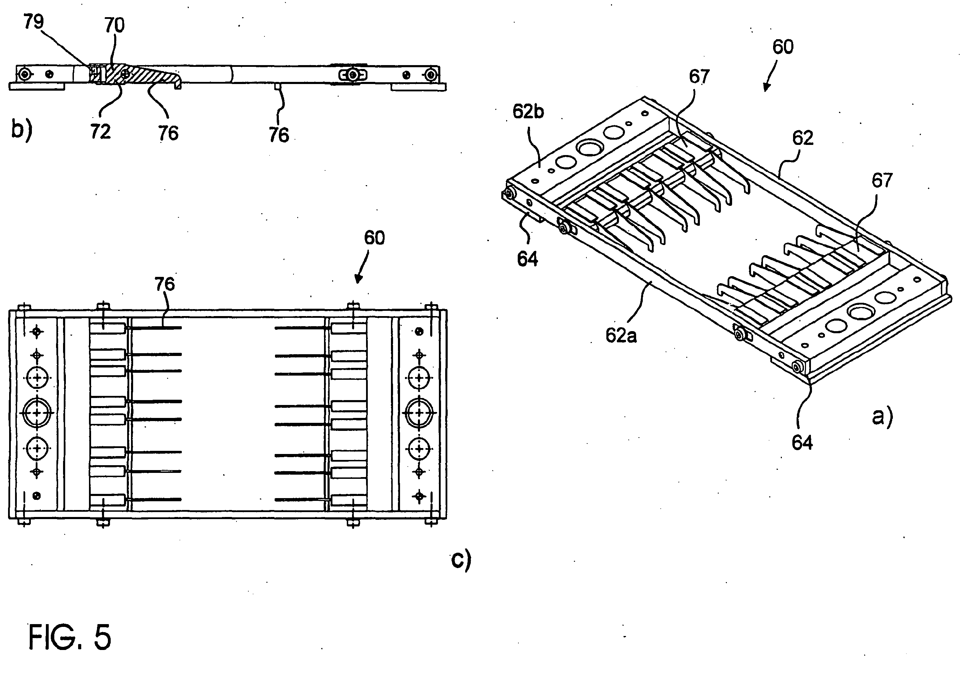

In dem in Fig. 4 gezeigten Beispiel wird die Anpresskraft über das Gewicht des Körpers 72 erreicht. Selbstverständlich ist es auch möglich, diese Kraft durch Federelemente aufzubringen, so dass die Körper 72 kleiner und leichter ausgebildet werden können. Ein entsprechendes Beispiel ist in Fig. 5 gezeigt, wobei der allgemeine Aufbau des Niederhalters 60 gleich bleibt. Bei dieser Ausführungsvariante bauen die Niederhalteköpfe 70 deutlich kleiner, da die Anpresskraft nicht mehr über das Eigengewicht sondern über Federn erzielt wird. Der Niederhaltekopf-Körper 72 kann folglich deutlich kleiner ausfallen, da ihm alleine die Befestigungsfunktion am Rahmen 62 zukommt. Je nach AVT-Prozess unterliegen die Federn einem thermischen Stress, der sich ungünstig auf die Federwirkung auswirken kann. Dies ist bei der Gewichtslösung ausgeschlossen.

Die Niederhalteköpfe 70 bestehen "quasi" nur noch aus den Niederhaltenadeln 70 (ohne mäanderförmigen Abschnitt) und einen kleinen Niederhaltekopf-Körper 72, über den jeder Niederhaltekopf 70 mit der Rahmenleiste verschwenkbar verbunden ist. In Fig. 5b ist schematisch eine Feder angedeutet und mit dem Bezugszeichen 79 gekennzeichnet. Dieser Feder drückt die Niederhaltenadel 76 nach unten.

In Fig. 5 ist darüber hinaus noch gut zu erkennen, dass die Spitzen der Niederhaltenadeln 76 nach unten über das Rahmenelement 62a hinausragen, so dass sie beim Aufsetzen des Niederhalters 60 auf eine Solarzelle 10 auf jeden Fall in Kontakt mit den auf der Solarzelle liegenden Streifen gelangen.

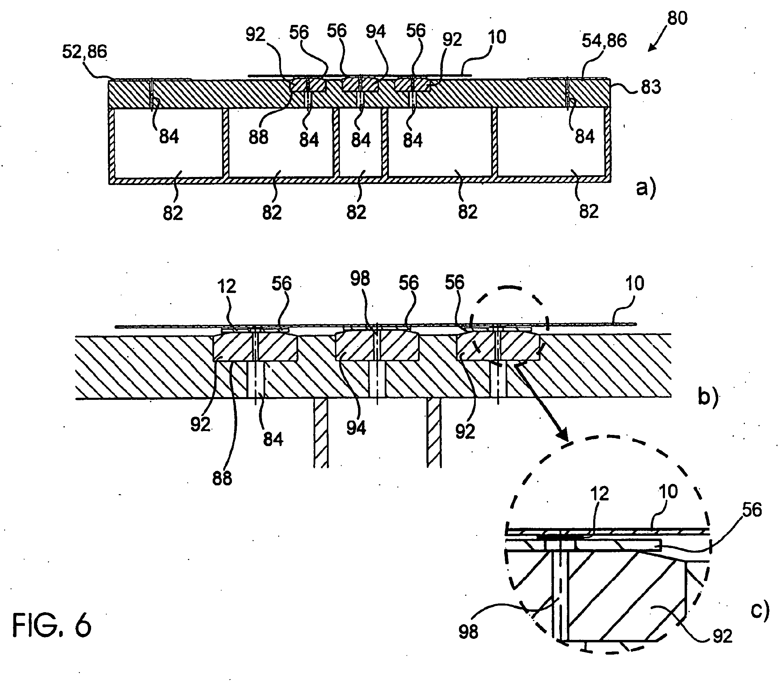

In Fig. 6 ist eine Schnittansicht einer Transporteinheit 80 dargestellt, die Teil des Transportmoduls 28 ist. Die Transporteinheit 80 umfasst eine Grundplatte 83, an deren Unterseite mehrere Saugkästen 82 angebracht sind. In der Grundplatte 83 sind Bohrungen 84 bzw. Saugöffnungen 84 vorgesehen, die eine Verbindung vom Saugkasten 82 an die Oberseite der Grundplatte 83 bereitstellen.

Die Grundplatte 83 dient im Wesentlichen dazu, die parallel hierzu verlaufenden Transportbänder 52 bis 56 abzustützen. Die beiden außen liegenden Transportbänder 52, 54 liegen direkt auf der Grundplatte 83 auf, wobei die in Fig. 3 angedeuteten Löcher 57 zu den Saugöffnungen 84 ausgerichtet sind.

Mit Hilfe der Saugöffnungen 84, den Löchern 57, dem Transportband 52 bzw. 54 und den Saugkästen 82 ist es möglich, den aufliegenden Niederhalter 60 anzusaugen und damit auf den Transportbändern zu fixieren. Wie bereits erwähnt, ist hierfür die Auflagefläche 64 so ausgestaltet, um eine möglichst hohe Ansaugkraft zu erzielen.

Das in der Mitte der Grundplatte 83 liegende Transportband 56 ist in drei einzelne Transportbänder 56 aufgeteilt und dient dazu, die Solarzellen 10 gleichmäßig abzustützen und zu transportieren.

Im Gegensatz zu den beiden Transportbändern 52, 54 ist es möglich, dass die Transportbänder 56 nicht direkt auf der Grundplatte 83 abgestützt sind, sondern es sind Leisten 92, 94 vorgesehen, die sich in Transportrichtung (in Fig. 6 senkrecht zur Zeichenebene) erstrecken und das jeweilige Transportband 56 abstützen. Die beiden äußeren Leisten 92 sind identisch ausgestaltet, unterscheiden sich jedoch zu der mittleren Leiste 94. Eine Leiste 92 oder 94 kann aus mehreren Einzelteilen aufgebaut sein (im Weiteren nur als Leiste bezeichnet).

Zur Aufnahme dieser Leisten 92, 94 sind in der Grundplatte 83 entsprechende Ausnehmungen 88 vorgesehen, derart, dass die Leisten einfach in diese Ausnehmungen eingelegt werden können. Es soll damit gewährleistet werden, dass ein Auswechseln dieser Leisten 92, 94 schnell und einfach möglich ist.

Jede der Leisten 92 kann Saugöffnungen 98 aufweisen, die dann mit Saugöffnungen 84 in der Grundplatte 83 in Verbindung stehen. Die Saugöffnungen 98 in den Leisten 92, 94 müssen jedoch nicht über die gesamte Leistenlänge vorgesehen sein, sondern werden je nach Anwendungsfall dort vorgesehen, wo ein Ansaugen benötigt wird. Darüber hinaus kann durch unterschiedliche Rasterung der Saugöffnungen (d.h. unterschiedliche Abstände der Saugöffnungen 98 zueinander) die Saugleistung in gewissem Rahmen eingestellt werden.

Wie bereits erwähnt, stützen die Leisten 92, 94 die Transportbänder 56 ab, wie dies gut in Fig. 6b zu erkennen ist. Die Transportbänder 56 sind dabei so ausgerichtet, dass deren Löcher 57 zu den Saugöffnungen 98 in den Leisten ausgerichtet sind. Damit ist es also möglich, die auf den Transportbändern 56 aufliegende Solarzelle anzusaugen und damit auf den Transportbändern zu fixieren.

Wie in Fig. 1a gut zu erkennen ist, liegen Längsabschnitte der beiden Streifen 12, 13 unterhalb jeder Solarzelle 10. Die beiden äußeren Transportbänder 56 sind nun so angeordnet, dass sie im Bereich der Streifen 12 bzw. 13 liegen. Folglich liegt im Falle von Solarzellen mit Vorder- und Rückkontakten zwischen Solarzelle und Transportband 56 an den beiden äußeren Leisten 52 jeweils noch ein Streifen 12 bzw. 13 dazwischen, während die Solarzelle 10 im Bereich der Leiste 94 direkt auf dem Transportband 56 aufliegt.

Auf Grund dessen ergibt sich ein Höhenunterschied bedingt durch die Dicke der Streifen 12, 13 zwischen den äußeren Transportbändern und dem mittleren Transportband, der bei gleicher Ausgestaltung der Leisten 92, 94 zu einer Biegung der Solarzelle 10 führen würde.

Um dies zu verhindern, haben die beiden äußeren Leisten 92 eine um die Dicke der Streifen 12, 13 verringerte Höhe gegenüber der mittleren Leiste 94. Damit kann gewährleistet werden, dass die Solarzelle plan auf den Transportbändern aufliegt und sich die Gefahr eines Bruchs deutlich reduziert.

Im Falle von der Verarbeitung von Rückseitenkontaktzellen, die auf der Sonnenseite keine Kontakte aufweisen, kann ohne Höhenversatz gearbeitet werden.

Da die Leisten 92, 94 leicht auswechselbar sind, kann die Transporteinheit 80 sehr schnell auf andere Solarzellen umgerüstet werden.

Darüber hinaus ermöglichen diese Leisten eine individuelle Einstellung bspw. der Saugleistung, indem die Anzahl der Saugöffnungen 98 entsprechend gewählt wird. Darüber hinaus sind andere Einstellungen mit Hilfe dieses Leistensystems ebenfalls möglich, ohne den Grundaufbau der Transporteinheit 80 verändern zu müssen.

Ferner ist es mit diesen Leisten möglich, Energie zuzuführen, um ein Verlöten der Streifen an der Unterseite der Solarzellen zu unterstützen, gezielt wärmetechnisch zu isolieren, usw.

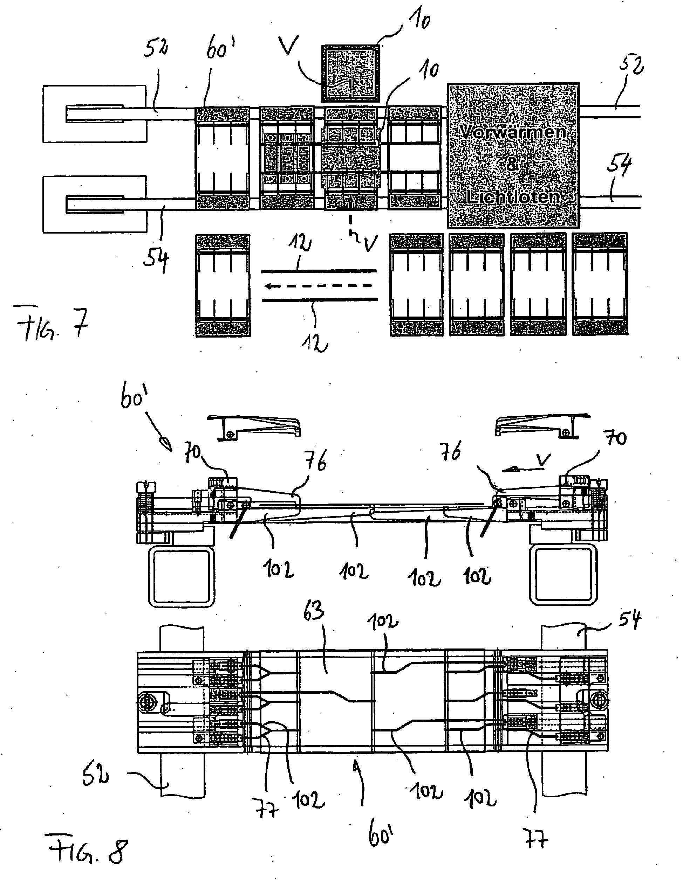

In Fig. 7 ist in Form eines schematischen Blockdiagramms eine weitere Ausführungsform einer Solarzellen-Verbindungsvorrichtung dargestellt. Der grundsätzliche Aufbau entspricht demjenigen der zuvor beschriebenen Vorrichtung, so dass auf die mit gleichen Bezugszeichen gekennzeichneten Teile nicht noch einmal eingegangen werden muss.

Ein wesentlicher Unterschied der in Fig. 7 gezeigten Ausgestaltung liegt darin, dass das mittlere Transportband 56, auf das die Solarzellen aufgelegt werden, entfallen ist.

Stattdessen werden modifizierte Niederhalteelemente 60' eingesetzt, die die Abstützfunktion des mittleren Transportbandes 56 übernehmen.

Bei der in Fig. 7 gezeigten Ausgestaltung weist das Niederhalteelement 60', wie es in Fig. 8 gezeigt ist, nach innen in den Bereich des Fensters 63 hineinragende Abstützelemente 102 auf, die so ausgelegt und positioniert sind, dass sie die unten liegenden Streifen und die darüber liegende Solarzelle abstützen. Durch die sehr schmale Bauweise dieser Abstützelemente 102 wird nur ein kleiner Bereich der Unterseite der Solarzelle von unten aus betrachtet abgedeckt.

Die geringe Abdeckung der Solarzellen-Unterseite ist dann von Vorteil, wenn der Verbindungsprozess von Streifen mit Solarzelle über Licht als Wärmequelle aktiviert wird.

Um auch ein Fixieren der auf der Oberseite der Solarzelle liegenden Streifen zu gewährleisten, werden die Niederhalteköpfe 70 so ausgestaltet, dass sie einerseits nach innen verschiebbar sind und andererseits dann nach unten wirken und die Streifen an die Oberseite der Solarzelle drücken.

Im Vergleich zu der zuvor im Detail erläuterten Ausgestaltung wird das Fixieren der oben liegenden Streifen nicht durch Auflegen des Niederhalteelements auf die Solarzelle erreicht, sondern vielmehr durch Verschieben der Niederhalteköpfe 70 nach innen, wie dies beispielsweise in Fig. 7 durch die Pfeile V gekennzeichnet ist. In Fig. 8 ist in der oberen Schnittdarstellung links der Niederhaltekopf 70 in der nach innen verschobenen Klemmposition gezeigt und auf der rechten Seite in der nach außen verschobenen nicht-klemmenden Position. Weitere Details des mechanischen Aufbaus dieses Niederhalteelements 60' können der Fig. 8 entnommen werden, so dass an dieser Stelle nicht weiter darauf einzugehen ist. Der grundsätzliche Aufbau der Niederhalteköpfe bzw. der Niederhaltenadeln 76 entspricht jenem des Niederhalteelements 60, wie es zuvor ausführlich beschrieben wurde.

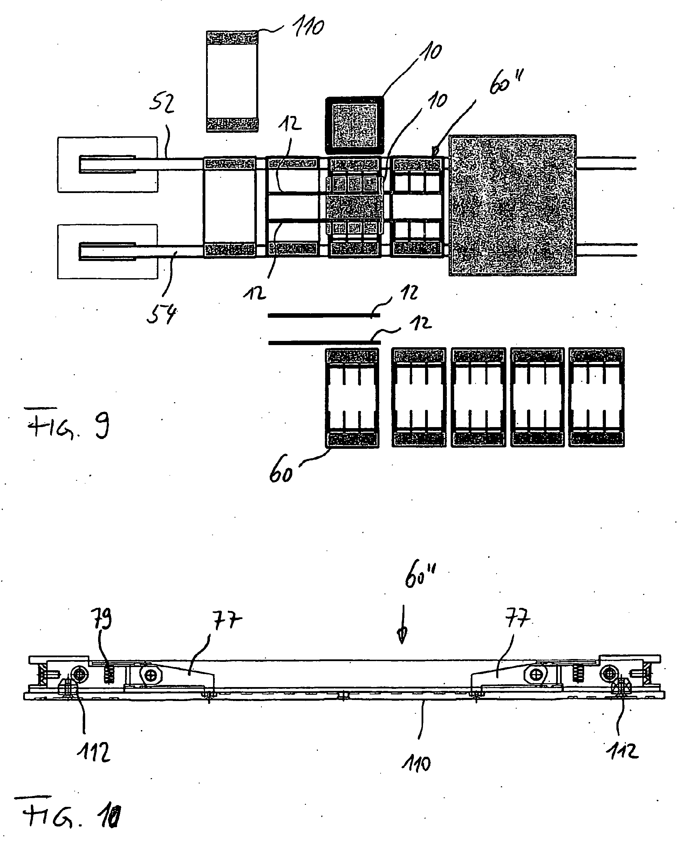

In Fig. 9 ist eine weitere Ausgestaltung einer Solarzellen-Verbindungsvorrichtung in Form eines schematischen Blockdiagramms dargestellt. Zur Vereinfachung werden auch hier mit zuvor beschriebenen Ausgestaltungen übereinstimmende Teile mit den gleichen Bezugszeichen gekennzeichnet und aus diesem Grund nicht nochmals im Detail erläutert.

Auch diese Ausgestaltung verzichtet auf ein mittleres Transportband 56, so dass die abstützende Funktion für die Solarzellen wiederum die Niederhalteelemente 60" übernehmen.

Im Vergleich zu der in Fig. 8 gezeigten Variante des Niederhalteelements 60' ist im vorliegenden Fall das Niederhalteelement 60" zweiteilig ausgestaltet. Es umfasst einerseits einen oberen Teil, der nahezu identisch zu dem Niederhalteelement 60 aufgebaut ist, und andererseits einen unteren Teil, der als Grundplatte 110 ausgebildet ist.

Die Grundplatte 110 wird - wie aus Fig. 9 ersichtlich - auf die beiden Transportbänder 52, 54 aufgelegt und überspannt folglich den dazwischen liegenden Bereich. Auf diese Grundplatte 110 werden zunächst die Streifen 12 und anschließend die Solarzelle 10 aufgelegt. Um nun die oben aufgelegten Streifen zu fixieren, wird der obere Teil in Form des Niederhalteelements 60 auf die Grundplatte 110 aufgelegt.

Der Prozessablauf, d.h. die Zuführung von Streifen, Solarzellen und Niederhalteelement 60 entspricht dem Prozess, der mit Bezug auf die Fig. 2 bis 6 beschrieben wurde. Es ist lediglich noch erforderlich, die Grundplatte 110 zuzuführen, um die Abstützfunktion des mittleren Transportbands 56 bereitzustellen.

Selbstverständlich sind Abwandlungen der verschiedenen zuvor erläuterten Ausgestaltungen möglich. Auch ist es denkbar, einzelne Merkmale der verschiedenen Ausgestaltungen miteinander zu kombinieren.

Darüber hinaus ist anzumerken, dass die verschiedenen Ausgestaltungen der Solarzellen-Verbindungsvorrichtungen für unterschiedliche Verbindungstechniken einsetzbar sind, wie bspw. Löten oder Leitkleben.

Zusammenfassend ist festzuhalten, dass mit Hilfe der erfindungsgemäßen Solarzellen-Verbindungsvorrichtung eine Herstellung von Strings 16 sehr flexibel und mit hoher Taktrate möglich ist, da die Herstellung bspw. durch Zurückführen einer Transportplatte - wie im Stand der Technik - nicht unterbrochen werden muss, sowie prozesstechnische Verbesserungen möglich werden.

Die erfindungsgemäßen Niederhalter 60 ermöglichen in einfacher Art und Weise ein Fixieren der Streifen auf den Solarzellen, ohne den Lötvorgang negativ zu beeinflussen.

Schließlich ist es mit dem erfindungsgemäßen Leistensystem möglich, selbst hochempfindliche, leicht zerbrechliche Solarzellen schonend zu transportieren, da ein Höhenunterschied bedingt durch die Streifen vermieden werden kann. Darüber hinaus können andere Eigenschaften, bspw. die Ansaugleistung, durch die auswechselbaren Leisten schnell und einfach gewählt werden.

Am Ende sei noch darauf hingewiesen, dass die beschriebenen erfindungsgemäßen Konzepte nicht nur alleine, sondern auch in Kombination miteinander eingesetzt werden können.

## Patentansprüche

1. Solarzellen-Verbindungsvotrichtung zum Fertigen von Solarzellen-Strings (16) aus einzelnen Solarzellen (10) und elektrisch leitfähigen Streifen (12), mit
- einem ersten Modul (22) zum Zusammenführen von Solarzellen und Streifen;
- einem zweiten Modul (24), das sich an das erste Modul anschließt, zum Verbinden der Streifen mit den Solarzellen;
- einem dritten Modul (28) zum Transport der Solarzellen vom ersten Modul durch das zweite Modul, hindurch,
**dadurch gekennzeichnet, dass**
das erste Modul (22) eine Vorrichtung (42) zum zuführen eines Streifen-Niederhalteelements (60) aufweist, mit dem die Streifen (12) beim Transport an der Solarzelle fixiert werden, und dass
das dritte Modul (28) ausgebildet ist, um das Niederhalteelement (60) zusammen mit der Solarzelle (10) und den daran fixierten Streifen (12) zu transportieren.

2. Solarzellen-Verbindungsvorrichtung nach Anspruch 1, **dadurch gekennzeichnet, dass** das dritte Modul (28) eine erste Transporteinrichtung aufweiset, die ein erstes einteiliges oder ein in mehrere parallel laufende Transportbänder unterteiltes Transportband (50, 56) umfasst, das die Solarzelle abstützt.

3. Solarzellen-Verbindungsvorrichtung nach Anspruch 2, **dadurch gekennzeichnet, dass** das erste Transportband (50) mehrere in Transportrichtung angeordnete Saug-Öffnungen (57) aufweist, die mit Saugkästen zusammenwirken, um auf dem Transportband (50) liegende Solatzellen darauf zu fixieren.

4. Solarzellen-Verbindugsvorrichtung nach Anspruch 1 oder 2, **dadurch gekennzeichnet, dass** das dritte Modul eine zweite Transporteinrichtung aufweist, die zwei parallel angeordnete Transportbänder (52, 54) umfasst, auf denen das Streifen-Niederhalteelement (60) zum Transport aufliegt.

5. Solarzellen-Verbindungsvorrichtung nach Anspruch 4, **dadurch gekennzeichnet, dass** das Streifen-Niederhalteelement (60) ein unteres Abstützelement aufweist, das die Solarzelle und die unteren Streifen abstützt, und das Abstützelement mehrere Abstütznadeln aufweist, oder als Grundplatte (83) ausgebildet ist, und auf den beiden parallelen Transportbändern aufliegt und auf die der andere Teil des Streifen-Niederhalteelements aufgelegt wird.

6. Solarzellen-Verbindungsvorrichtung nach einem der Ansprüche 4 oder 5, **dadurch gekennzeichnet, dass** die zwei parallelen Transportbänder (52, 54) in deren Längsrichtung angeordnete Saugöffnungen (57) aufweisen, die mit Saugkästen zusammenwirken, um die Niederhalteelemente (60) bzw. Grundplatten (83) auf den Transportbändern zu fixieren.

7. Solarzellen-Verbindungsvorrichtung nach einem der vorhergehenden Ansprüche, **dadurch gekennzeichnet, dass** das dritte Modul eine dritte Transporteinrichtung (34) aufweist, die ausgelegt ist, Niederhalteelemente (60) am Ende des zweiten Moduls (24) oder ggf. nach weiteren prozesstechnischen Zwischenschritten von der Solarzelle abzuheben und zurück zum ersten Modul (22) zu transportieren.

8. Solarzellen-Verbindungsvorrichtung nach einem der vorhergehenden Ansprüche, **dadurch gekennzeichnet, dass** dem zweiten Modul (24) eine Löteinrichtung (30), vorzugsweise ein Lötofen, zum Verlöten der Streifen auf den Solarzellen zugeordnet ist, wobei die Solarzellen die Löteinrichtung auf dem Transportband liegend zusammen mit dem Niederhalteelement durchlaufen.

9. Solarzellen-Verbindungsvorrichtung nach einem der vorhergehenden Ansprüche, **dadurch gekennzeichnet, dass** die erste Transporteinrichtung eine Leisteneinrichtung aufweist, die drei sich in Transportrichtung erstreckende Leisten (92, 94) umfasst, auf denen die Transportbänder (56) aufliegen, wobei zumindest eine erste Leiste (92), in einem Bereich mit darüber liegendem Streifen und zumindest eine zweite Leiste (94) in einem Bereich ohne darüber liegendem Streifen angeordnet ist, und wobei die ersten und die zweiten Leisten unterschiedlich ausgebildet sind, um die Dicke des zwischen Solarzelle und Transportband liegenden Streifens auszugleichen.

10. Solarzellen-Verbindungsvorrichtung nach Anspruch 9, **dadurch gekennzeichnet, dass** die Leisten (92, 94) auswechselbar ausgestaltet sind, und/oder die einzelnen Leisten Längsabschnitte aufweisen, die Saugöffnungen aufweisen, die mit den Saugkästen zum Ansaugen der Solarzellen zusammenwirken, und/oder die einzelnen Leisten direkt oder indirekt beheizt oder gehühlt oder wärmeisolierend ausgeführt sind.

11. Streifen-Niederhaltevorrichtung für eine Solarzellen-Verbindungsvorrichtung, nach einem der Ansprüche 1 bis 10, **gekennzeichnet durch**
- einen Rahmen (62), der an seinen beiden Randbereichen Auflageflächen (64) und im mittleren Bereich ein Fenster (63) aufweist;
- eine Vielzahl von Niederhalteköpfen (70), die in zumindest zwei Reihen seitlich des Fensters angeordnet sind, und jeweils eine Niederhaltenadel (76) aufweisen, wobei die Niederhalteköpfe schwenkbar am Rahmen derart gehalten sind, dass die Niederhaltenadeln (76) auf einen Streifen bewegbar sind.

12. Streifen-Niederhaltevorrichtung nach Anspruch 11, **dadurch gekennzeichnet, dass** die Auflageflächen (64) ausgelegt sind, um auf den Transportbändern (51, 54) plan aufzuliegen.

13. Streifen-Niederhaltevorrichtung nach einem der Ansprüche 11 oder 12, **dadurch gekennzeichnet, dass** die Niederhalteköpfe (70) durch ihr eigenes Gewicht geschwenkt werden, um die Niederhaltenadeln (76) nach unten auf den Streifen zu bewegen, und/oder den Niederhalteköpfen (70) jeweils zumindest eine Feder (79) zugeordnet ist, die die Bewegung der Niederhaltenadeln nach unten auf die Streifen bewirken, und/oder die Niederhaltenadeln einen federnden, vorzugsweise mäanderförmigen Abschnitt (77) aufweisen.

14. Transportvorrichtung für eine Solarzellen-Verbindungsvorrichtung, nach einem der Ansprüche 1 bis 10, mit einem Rahmen, der ein Transportband abstützt, **gekennzeichnet durch**
- mehreren Leisten (92, 94), die parallel zueinander angeordnet sind und sich in Transportrichtung erstrecken, wobei zumindest eine erste Leiste (92) im Bereich eines mit der Unterseite einer Solarzelle zu verbindenden Streifens liegt, und zumindest eine andere zweite Leiste (94) in einem Bereich ohne Streifen liegt,
- in Transportrichtung verlaufende Ausnehmungen (88), im Rahmen, die ausgelegt sind, um jeweils eine Leiste wechselbar aufzunehmen, wobei die Leisten im eingelegten Zustand das Transportband abstützen und wobei die ersten und die zweiten Leisten unterschiedliche Höhen haben, um einen Höhenunterschied bedingt **durch** die Dicke von Streifen zwischen Solarzelle und Transportband auszugleichen.

15. Transportvorrichtung nach Anspruch 14, **dadurch gekennzeichnet, dass** die Leiste (92, 94) zumindest längsabschnittsweise Saugbohrungen aufweist, die sich von der dem Transportband zugewandten Seite zur gegenüberliegenden Seite erstrecken.

## Claims

1. A solar cell connecting apparatus for manufacturing solar cell strings (16) of individual solar cells (10) and electrically conductive strips (12), having
- a first module (22) for joining solar cells and strips together;
- a second module (24), which is connected to the first module, for connection of the strips with the solar cells;
- a third module (28) for transportation of the solar cells from the first module through the second module,
**characterized in that**
the first module (22) has an apparatus (40) for supplying a strip retaining element (60) by means of which the strips (12) are fixed on the solar cell during transportation, and that
the third module (28) is of designed in order to transport the retaining element (60) together with the solar cell (10) and the strips (12) fixed to it.

2. The solar cell connecting apparatus as claimed in claim 1, **characterized in that** the third module (28) has a first transport device which comprises a first conveyer belt (50,56), which is integral or is subdivided into a plurality of parallel-running conveyer belts and supports the solar cell.

3. The solar cell connecting apparatus as claimed in claim 2, **characterized in that** the first conveyer belt (50) has a plurality of suction openings (57) which are arranged in the transportation direction and interact with suction boxes in order to fix solar cells located on the conveyer belt (50) thereon.

4. The solar cell connecting apparatus as claimed in claim 1 or 2, **characterized in that** the third module has a second transport device which comprises two parallel-arranged conveyer belts (52,54) on which the strip retaining element (60) is located for transport.

5. The solar cell connecting apparatus as claimed in claim 4, **characterized in that** the strip retaining element (60) has a lower supporting element which supports the solar cell and the lower strips, and the supporting element has a plurality of supporting needles which support the solar cell and the lower strips, or is in the form of a baseplate (83) which rests on the two parallel conveyer belts and on which the other part of the strip retaining element is placed.

6. The solar cell connecting apparatus as claimed in one of claims 4 or 5, **characterized in that** the two parallel conveyer belts (52,54) have suction openings (57) which are arranged in their longitudinal direction and interact with suction boxes in order to fix the retaining elements (60) and/or baseplates (83) on the conveyer belts.

7. The solar cell connecting apparatus as claimed in one of the preceding claims, **characterized in that** the third module has a third transport device (34) of designed to pick up retaining elements (60) at the end of the second module (24), or, if appropriate, after further process intermediate steps from the solar cell, and to transport them back to the first module (22).

8. The solar cell connecting apparatus as claimed in one of the preceding claims, **characterized in that** the second module (24) has an associated soldering device (30), preferably a soldering oven, for soldering the strips to the solar cells, with the solar cells passing through the soldering device, lying on the conveyer belt, together with the retaining element.

9. The solar cell connecting apparatus as claimed in one of the preceding claims, **characterized in that** the first transport device has a bar device which comprises three bars (92,94) extending in the transport direction, on which the conveyer belts (56) rest, with at least a first bar (92) being arranged in an area with opposite strips and with at least one second bar (94) being arranged in an area without opposite strips, and the first and the second bars being of designed differently in order to compensate for the thickness of the strip located between the solar cell and the conveyer belt.

10. The solar cell connecting apparatus as claimed in claim 9, **characterized in that** the bars are interchangeable, and/or the individual bars have longitudinal sections which have suction openings which interact with the suction boxes to provide suction for the solar cells, and/or the individual bars are adapted to be indirectly or directly heatable or coolable or thermally insulatable.

11. A strip retaining apparatus for a solar cell connecting apparatus, as claimed in one of claims 1 to 10, **characterized by**
- a frame (62) which has contact surfaces (64) on its two edge areas and has a window (63) in the central area;
- a multiplicity of retaining heads (70) which are arranged in at least two rows at the side of the window and each have a retaining needle (76), with the retaining heads being held on the frame such that they can pivot such that the retaining needles (76) can be moved on to a strip.

12. The strip retaining apparatus as claimed in claim 11, **characterized in that** the contact surfaces (64) are of designed in order to rest flat on the conveyer belts (52,54).

13. The strip retaining apparatus as claimed in one of claims 11 or 12, **characterized in that** the retaining heads (70) are pivoted by their own weight in order to move the retaining needles (76) downwards towards the strips, and/or the retaining heads (79) each have at least one associated spring (79), which springs move the retaining needles downwards on to the strips, and/or the retaining needles have a sprung, preferably meandering section (77).

14. A transport apparatus for a solar cell connecting apparatus, as claimed in one of claims 1 to 10, having a frame which supports a conveyer belt, **characterized by**
- a plurality of bars (92,94), which are arranged parallel to one another and extend in the transport direction, with at least a first bar (92) being located in the area of a strip to be connected to the lower piece of a solar cell and with at least one other second bar (94) being located in an area without strips,
- recesses (88) in the frame, which run in the transport direction and are designed to each hold one bar interchangeably with the bars supporting the conveyer belt in the inserted state, and with the first and the second bars being of different height in order to compensate for any height difference caused by the thickness of strips between the solar cell and the conveyer belt.

15. The transport apparatus as claimed in claim 14, **characterized in that** the bar (92,94) has suction holes at least in some longitudinal sections, which extend from the side facing the conveyer belt to the opposite side.

## Revendications

1. Dispositif de mise en contact de cellules solaires pour fabriquer des chaînes de cellules solaires (16) à partir de cellules solaires individuelles (10) et de rubans électriquement conducteurs (12), comprenant :
- un premier module (22) pour rassembler des cellules solaires et des rubans ;
- un deuxième module (24) qui se raccorde au premier module, pour mettre en contact les rubans et les cellules solaires ;
- un troisième module (28) pour le transport des cellules solaires du premier module à travers le deuxième module,
**caractérisé en ce que**
le premier module (22) présente un dispositif (40) pour acheminer les rubans (12, 13) et un élément de maintien des rubans (60), avec lequel les rubans (12) sont fixés sur la cellule solaire lors du transport et **en ce que**
le troisième module (28) est réalisé pour transporter l'élément de maintien (60) conjointement avec la cellule solaire (10) et le ruban (12) fixé dessus.

2. Dispositif de mise en contact de cellules solaires selon la revendication 1, **caractérisé en ce que** le troisième module (28) présente un premier dispositif de transport qui comprend une première bande de transport (50, 56) d'une seule pièce ou divisée en plusieurs bandes de transport se déplaçant en parallèle, qui supporte la cellule solaire.

3. Dispositif de mise en contact de cellules solaires selon la revendication 2, **caractérisé en ce que** la première bande de transport (50) présente plusieurs ouvertures d'aspiration (57) disposées dans la direction de transport, qui coopèrent avec des caisses aspirantes, afin de fixer dessus des cellules solaires disposées sur la bande de transport (50).

4. Dispositif de mise en contact de cellules solaires selon la revendication 1 ou 2, **caractérisé en ce que** le troisième module présente un deuxième dispositif de transport qui comprend deux bandes de transport (52, 54) disposées en parallèle, sur lesquelles repose l'élément de maintien des rubans (60) pour le transport.

5. Dispositif de mise en contact de cellules solaires selon la revendication 4, **caractérisé en ce que** l'élément de maintien des rubans (60) présente un élément de support inférieur qui supporte la cellule solaire et les rubans inférieurs, et l'élément de support présente plusieurs aiguilles de support ou est réalisé sous forme de plaque de base (83), et repose sur les deux bandes de transport parallèles et sur laquelle l'autre partie de l'élément de maintien des rubans est posée.

6. Dispositif de mise en contact de cellules solaires selon l'une quelconque des revendications 4 ou 5, **caractérisé en ce que** les deux bandes de transport parallèles (52, 54) présentent des ouvertures d'aspiration (57) disposées dans leur direction longitudinale, qui coopèrent avec des caisses aspirantes afin de fixer les éléments de maintien (60) ou les plaques de base (83) sur les bandes de transport.

7. Dispositif de mise en contact de cellules solaires selon l'une quelconque des revendications précédentes, **caractérisé en ce que** le troisième module présente un troisième dispositif de transport (34) qui est conçu pour soulever de la cellule solaire des éléments de maintien (60) à l'extrémité du deuxième module (24) ou éventuellement après d'autres étapes techniques de processus intermédiaires, et pour les ramener au premier module (22).

8. Dispositif de mise en contact de cellules solaires selon l'une quelconque des revendications précédentes, **caractérisé en ce que** l'on associe au deuxième module (24) un dispositif de brasage (30), de préférence un four de brasage pour le brasage des rubans sur les cellules solaires, les cellules solaires passant à travers le dispositif de brasage couchées sur la bande de transport, conjointement avec l'élément de maintien.

9. Dispositif de mise en contact de cellules solaires selon l'une quelconque des revendications précédentes, **caractérisé en ce que** le premier dispositif de transport présente un dispositif de barres qui comprend trois barres (92, 94) s'étendant dans la direction de transport, sur lesquelles reposent les bandes de transport (56), au moins une première barre (92) étant disposée dans une région sur laquelle sont posés des rubans, et au moins une deuxième barre (94) dans une région exempte de rubans, et les première et deuxième barres étant réalisées différemment, pour compenser l'épaisseur du ruban situé entre la cellule solaire et la bande de transport.

10. Dispositif de mise en contact de cellules solaires selon la revendication 9, **caractérisé en ce que** les barres (92, 94) sont configurées de manière remplaçable, et/ou les barres individuelles présentent des portions longitudinales qui présentent des ouvertures d'aspiration qui coopèrent avec les caisses aspirantes pour aspirer les cellules solaires, et/ou les barres individuelles sont configurées de manière chaufferable ou refroidirable ou isolerable thermiquement directement ou indirectement.

11. Dispositif de maintien de rubans pour un dispositif de mise en contact de cellules solaires selon l'une quelconque des revendications 1 à 10, **caractérisé par** :
- un cadre (62) qui présente sur ses deux régions de bord des surfaces d'appui (64) et dans la région centrale une fenêtre (63) ;
- une pluralité de têtes de maintien (70) qui sont disposées dans au moins deux rangées latéralement à la fenêtre, et présentent à chaque fois une aiguille de maintien (76), les têtes de maintien étant maintenues de manière pivotante sur le cadre de telle sorte que les aiguilles de maintien (76) puissent être déplacées sur un ruban.

12. Dispositif de maintien de rubans selon la revendication 11, **caractérisé en ce que** les surfaces d'appui (64) sont conçues pour s'appliquer à plat sur les bandes de transport (52, 54).

13. Dispositif de maintien de rubans selon l'une quelconque des revendications 11 ou 12, **caractérisé en ce que** les têtes de maintien (70) sont pivotées sous l'effet de leur propre poids, afin de déplacer les aiguilles de maintien (76) vers le bas sur les rubans, et/ou à chaque fois au moins un ressort (79) est associé aux têtes de maintien (70), qui provoquent le déplacement des aiguilles de maintien vers le bas sur les rubans, et/ou les aiguilles de maintien présentent une portion (77) élastique, de préférence en forme de méandre.

14. Dispositif de transport pour un dispositif de mise en contact de cellules solaires selon l'une quelconque des revendications 1 à 10, comprenant un cadre, qui supporte une bande de transport, **caractérisé par** :
- plusieurs barres (92, 94), qui sont disposées parallèlement les unes aux autres et s'étendent dans la direction de transport, au moins une première barre (92) étant située dans la région d'un ruban à assembler au côté inférieur d'une cellule solaire, et au moins une autre deuxième barre (94) étant située dans une région sans ruban,
- des évidements (88) s'étendant dans la direction de transport, dans le cadre, qui sont conçus pour recevoir à chaque fois une barre remplaçable, les barres supportant dans l'état installé la bande de transport et les première et deuxième barres ayant des hauteurs différentes, afin de compenser une différence de hauteur due à l'épaisseur des rubans entre la cellule solaire et la bande de transport.

15. Dispositif de transport selon la revendication 14, **caractérisé en ce que** la barre (92, 94) présente des alésages d'aspiration au moins dans leur portion longitudinale, qui s'étendent depuis le côté tourné vers la bande de transport vers le côté opposé.
